# EUROPEAN PATENT SPECIFICATION

(11) **EP 2 829 568 B1**
(45) Date of publication and mention of the grant of the patent: **14.03.2018**
(21) Application number: 13764176.7
(22) Date of filing: 21.03.2013
(51) Int. Cl.: B32B 15/08, B32B 15/14, B32B 27/20, B32B 27/28, B32B 27/36, B32B 27/38, B32B 5/02, C08J 5/24, C08L 71/12, C08L 87/00, C08G 59/40, C08G 65/40, C08G 65/48, H01B 3/42, H05K 1/03

(54) **PREPREG AND LAMINATED BOARD**
PREPREG UND LAMINIERTES BRETT
PRÉIMPRÉGNÉ ET PLAQUE STRATIFIÉE

(30) Priority: 23.03.2012 JP 2012066574; 31.08.2012 JP 2012191444
(43) Date of publication of application: 28.01.2015
(73) Proprietor: Mitsubishi Gas Chemical Company, Inc., Tokyo 100-8324 (JP)
(72) Inventor: ITO, Shoichi, Tokyo 125-0051 (JP); YAGINUMA, Michio, Tokyo 125-0051 (JP); OKA, Naoki, Tokyo 125-0051 (JP); KUDO, Masataka, Tokyo 125-0051 (JP)
(74) Representative: Müller-Boré & Partner Patentanwälte PartG mbB
(86) International application number: PCT/JP2013/058075
(87) International publication number: WO 2013/141298

(56) References cited:
- CA-C- 1 336 845
- JP-A- 2010 138 364
- JP-A- 2010 138 364
- JP-A- 2010 138 366
- JP-A- 2010 138 366

## Description

The present invention relates to a prepreg and laminated board to be used in a printed wiring board to form an electric circuit.

In recent years, it has become necessary for personal computers, servers, and other such information terminal devices and internet routers, optical communications, and other such communication devices to process large volumes of data at high speed, and advances are being made in raising the speed and frequency of the electrical signals. In association with this, the laminated boards for printed wiring boards used in these devices must have a lower dielectric constant and lower dielectric loss tangent in addition to the flame retardancy, heat resistance, peel strength with copper foil and the like, and other such properties required in the past. Various attempts are being made to construct resin compositions to meet these demands.

Formulations that include a resin having a low dielectric constant and low dielectric loss tangent, such as fluorine resin, cyanic acid ester resin, polyphenylene ether resin, and vinyl compounds consisting mainly of styrene, in a resin composition are known to impart electrical properties to such materials (for example, see Patent References 1 and 2).

Laminated boards for printed wiring boards are usually made using a prepreg obtained by uniformly dispersing the components of a resin composition in an organic solvent, using the obtained varnish to impregnate or coat glass cloth or other such base material, and drying.

Polyphenylene ether or another such compound having low polarity is often used as the main component of a resin having a low dielectric loss tangent, and low-polarity toluene or the like that matches the polarity of the main component is used as the organic solvent (for example, see Patent Reference 3).

The use of toluene, however, tends to be voluntarily restricted from the viewpoint of environmental pollution, and another solvent must be used.

On the other hand, polar solvents are not generally used as a resin component for such a low dielectric loss tangent, and no study has been made adequately on how the residual solvent in the prepreg affects the produced prepreg and the like.

Patent Reference 1: JP Kokai 11-124433
Patent Reference 2: JP Kokai 2010-174242
Patent Reference 3: JP Kokai 2005-239767

JP 2010-138364A describes a resin composition, prepreg and metal foil laminated plate. JP 2010-138366A describes a resin composition, prepreg and metal foil-clad laminate. CA 1,336,845 describes curable polymer compositions comprising polyphenylene ethers and polyepoxides.

The purpose of the present invention is to provide a prepreg that achieves a low dielectric loss tangent when a laminated board is produced, despite the use of a polar solvent.

As a result of in-depth studies of the above problems, the present inventors discovered that making the residual amount of polar solvent in a prepreg be 3 mass% or less allows the dielectric loss tangent at 10 GHz of the laminated board produced using the prepreg to be 0.001-0.007 and thereby achieved the present invention.

Specifically, the present invention provides:
[1] A prepreg produced by impregnating or coating a base material with a varnish containing an inorganic filler, a polar solvent containing at least propylene glycol monomethyl ether acetate, and a resin composition containing 50 mass% or more of polyphenylene ether, and subjecting the base material treated to a drying step, wherein
   the polar solvent content of the prepreg is 3 mass% or less.
[2] The prepreg according to [1], wherein the polar solvent further contains at least one selected from the group consisting of acetone, methyl ethyl ketone, N,N-dimethylformamide, and dimethylacetamide.
[3] The prepreg according to [1] or [2], wherein the polar solvent content of the varnish is 10-180 parts by mass per 100 total parts by mass of the resin composition and the inorganic filler.
[4] The prepreg according to any of [1] - [3], wherein a treatment is conducted for 2-30 minutes at 120-200°C in the drying step.
[5] The prepreg according to any of [1] - [4], wherein the resin composition further contains at least one selected from the group consisting of an epoxy resin, phenol resin, cyanate compound, and polycarbonate.
[6] The prepreg according to any of [1] - [5], wherein the polyphenylene ether has a number average molecular weight ranging 500-3000.
[7] The prepreg according to any of [1] - [6], wherein the polyphenylene ether is represented by general formula (4): 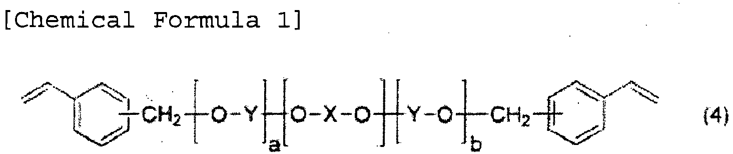 in which
   -(O-X-O)- constitutes a structure represented by general formula (5): 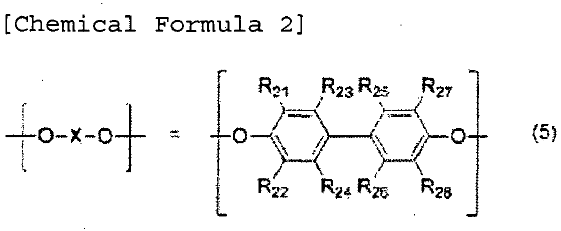 in which R₂₁, R₂₂, R₂₃, R₂₇, R₂₈ may be the same or different and are phenyl groups or alkyl groups having six or fewer carbon atoms, R₂₄, R₂₅, R₂₆ may be the same or different and are hydrogen atoms, phenyl groups or alkyl groups having six or fewer carbon atoms, or general formula (6): 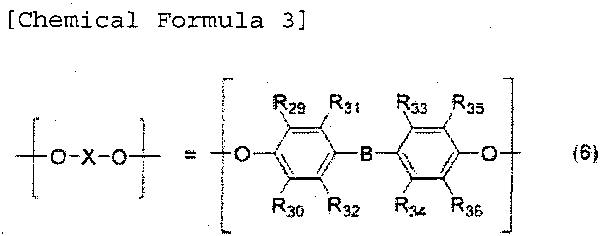 in which R₂₉, R₃₀, R₃₁, R₃₂, R₃₃, R₃₄, R₃₅, R₃₆ may be the same or different and are hydrogen atoms, phenyl groups or alkyl groups having six or fewer carbon atoms, -B- is a linear, branched, or cyclic divalent hydrocarbon group having 20 or fewer carbon atoms; and
   -(Y-O)- is represented by general formula (7): 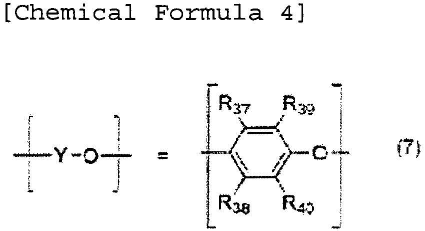 in which R₃₉, R₄₀ may be the same or different and are phenyl groups or alkyl groups having six or fewer carbon atoms; R₃₇, R₃₈ may be the same or different and are hydrogen atoms, phenyl groups or alkyl groups having six or fewer carbon atoms;
   where one or more types of structures are arranged randomly and a and b represent integers of 0-100, at least one of which is not zero.
[8] The prepreg according to any of [1] - [7], wherein the resin composition contains an epoxy resin and the epoxy resin content of the resin composition is 1-30 mass%.
[9] The prepreg according to any of [1] - [8], wherein the resin composition contains a cyanate compound and the cyanate compound content of the resin composition is 1-30 mass%.
[10] The prepreg according to any of [1] - [9], wherein the resin composition contains a brominated polycarbonate oligomer and the polycarbonate oligomer content of the resin composition is 2-10 mass%.
[11] The prepreg according to any of [1] - [10], wherein the inorganic filler is at least one selected from the group consisting of natural silica, fused silica, synthetic silica, amorphous silica, hollow silica, short glass fibers, and talc.
[12] The prepreg according to any of [1] - [11], wherein an amount of dust falling as measured as follows is 5 mass% or less: placing the prepreg having the size of 40 mm x 345 mm on an aluminum sheet, passing a cylindrical SUS roll having weight of 1 kg and diameter of 25 mm over the prepreg, calculating the prepreg weight loss before and after, and calculating an average value of three measurements of the prepreg weight loss.
[13] A laminated board produced using the prepreg according to any of [1] - [12], wherein the laminated board has a dielectric loss tangent at 10 GHz of 0.001-0.007, and wherein the dielectric loss tangent at 10 GHz is measured by a cavity perturbation method.
[14] A metal foil-clad laminated board produced using the prepreg according to any of [1] - [12] and metal foil.
[15] A printed wiring board containing an insulating layer and a conductor layer formed on the surface of the insulating layer, wherein the insulating layer contains the prepreg according to any of [1]-[12], and has a dielectric loss tangent at 10 GHz of 0.001-0.007, and wherein the dielectric loss tangent at 10 GHz is measured by a cavity perturbation method.

The prepreg of the present invention achieves a low dielectric loss tangent when a laminated board is produced, is suitable for printed wiring board materials that support higher densification, and is of great industrial utility.

The prepreg of the present invention also suppresses dust falling, a phenomenon whereby resin dust falls from the prepreg, during and after prepreg manufacture and enables stable production.

Embodiments of the invention are explained below. The following embodiments are intended as examples to explain the present invention, and the present invention is not limited to these embodiments alone.

The present invention relates to a prepreg produced by impregnating or coating a base material with a varnish containing an inorganic filler, a polar solvent containing at least propylene glycol monomethyl ether acetate, and a resin composition containing 50 mass% or more of polyphenylene ether followed by drying step, wherein the polar solvent content of the prepreg is 3 mass% or less and the dielectric loss tangent at 10 GHz of a laminated board produced using the prepreg is 0.001-0.007.

Preferred as the polyphenylene ether is a polymer containing at least a repeating unit represented by general formula (1): 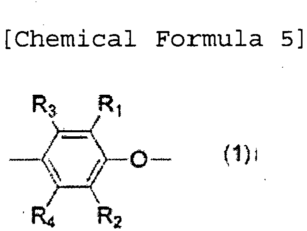 in which R₁, R₂, R₃, and R₄ may be the same or different and represent alkyl groups having six or fewer carbon atoms, aryl groups, halogens, or hydrogen. This polymer may also contain a repeating unit represented by general formula (2): 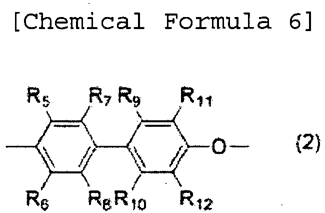 in which R₅, R₆, R₇, R₁₁, R₁₂ may be the same or different and are phenyl groups or alkyl groups having six or fewer carbon atoms, and R₈, R₉, R₁₀ may be the same or different and are hydrogen atoms, phenyl groups or alkyl groups having six or fewer carbon atoms;
and/or a repeating unit represented by general formula (3): 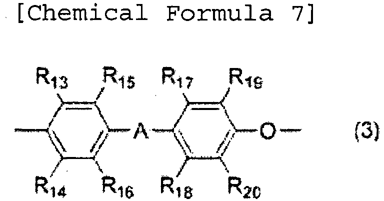 in which R₁₃ , R₁₄ , R₁₅, R₁₆, R₁₇, R₁₈, R₁₉, R₂₀ may be the same or different and are hydrogen atoms, phenyl groups or alkyl groups having six or fewer carbon atoms, -A- is a linear, branched, or cyclic divalent hydrocarbon group having 20 or fewer carbon atoms.

Modified polyphenylene ether partially or completely functionalized by a vinylbenzyl group or other such ethylenic unsaturated group, epoxy group, amino group, hydroxyl group, mercapto group, carboxyl group, silyl group, or the like can also be used as the polyphenylene ether. These may be used individually or in combinations of two or more types.

The method for producing modified polyphenylene ether is not particularly limited as long as the effects of the present invention are obtained. For example, those functionalized by vinylbenzyl groups can be produced by dissolving bifunctional phenylene ether oligomer and vinylbenzyl chloride in a solvent, reacting by adding a base while heating and stirring, and then solidifying the resin. Those functionalized by carboxyl groups are produced, for example, by melting and kneading an unsaturated carboxylic acid or functionalized derivative thereof with polyphenylene ether with or without a radical initiator present and causing a reaction. Alternatively, they are produced by dissolving polyphenylene ether and an unsaturated carboxylic acid or functional derivative thereof in an organic solvent with or without a radical initiator present and causing a reaction in solution.

The polyphenylene ether preferably contains modified polyphenylene ether having ethylenic unsaturated groups at both ends. Examples of ethylenic unsaturated groups include an ethenyl group, allyl group, acryl group, methacryl group, propenyl group, butenyl group, hexenyl group, octenyl group, or other such alkenyl group, cyclopentenyl group, cyclohexenyl group, or other such cycloalkenyl group, vinylbenzyl group, vinylnaphthyl group, or other such alkenylaryl group. A vinylbenzyl group is preferred. The two ethylenic unsaturated groups at both ends may be the same functional group or different functional groups.

In the present invention, the polyphenylene ether particularly preferably contains modified polyphenylene ether represented by general formula (4): 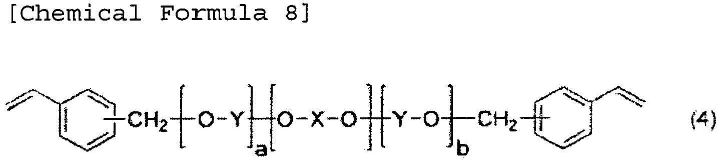 in which
-(O-X-O)- constitutes a structure represented by general formula (5): 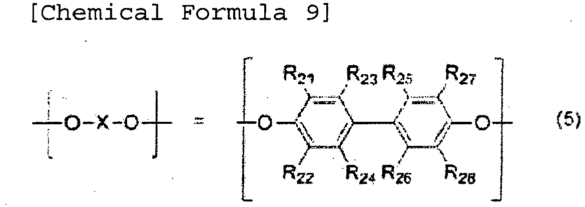 in which R₂₁, R₂₂, R₂₃, R₂₇, R₂₈ may be the same or different and are phenyl groups or alkyl groups having six or fewer carbon atoms, R₂₄, R₂₅, R₂₆ may be the same or different and are hydrogen atoms, phenyl groups or alkyl groups having six or fewer carbon atoms,
or general formula (6): 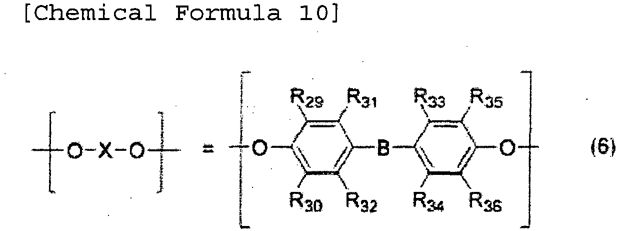 in which R₂₉, R₃₀, R₃₁ R₃₂, R₃₃, R₃₄, R₃₅, R₃₆ may be the same or different and are hydrogen atoms, phenyl groups or alkyl groups having six or fewer carbon atoms, -B- is a linear, branched, or cyclic divalent hydrocarbon group having 20 or fewer carbon atoms; and
-(Y-O)- is represented by general formula (7): 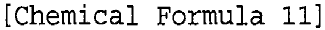 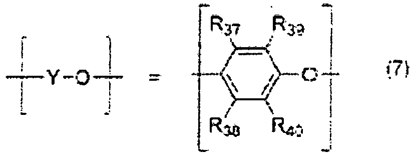 in which R₃₉, R₄₀ may be the same or different and are phenyl groups or alkyl groups having six or fewer carbon atoms; R₃₇, R₃₈ may be the same or different and are hydrogen atoms, phenyl groups or alkyl groups having six or fewer carbon atoms; where one or more types of structures are arranged randomly; and a and b represent integers of 0-100, at least one of which is not zero.

Examples of -B- in general formula (6) include, but are not limited to, methylene, ethylidene, 1-methylethylidene, 1,1-propylidene, 1,4-phenylenebis(1-methylethylidene), 1,3-phenylenebis(1-methylethylidene), cyclohexylidene, phenylmethylene, naphthylmethylene, 1-phenylethylidene, and other such divalent organic groups.

Among the polyphenylene ethers, polyphenylene ethers in which R₂₁, R₂₂, R₂₃, R₂₇, R₂₈, R₃₉, R₄₀ are alkyl groups having three or fewer carbon atoms and R₂₄, R₂₅, R₂₆, R₂₉, R₃₀, R₃₁, R₃₂, R₃₃, R₃₄, R₃₅, R₃₆, R₃₇, R₃₈ are hydrogen atoms or alkyl groups having three or fewer carbon atoms are preferred. Polyphenylene ether in which -(O-X-O)- represented by general formula (5) or general formula (6) is formula (8), general formula (9), or general formula (10) and -(Y-O)- represented by general formula (7) is formula (11) or formula (12) or a structure in which formula (11) and formula (12) are randomly arranged is more preferred. 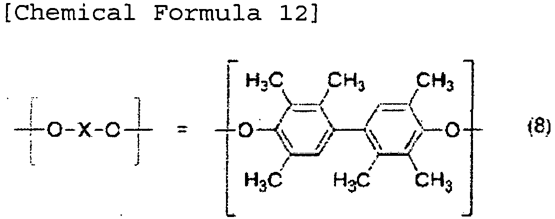 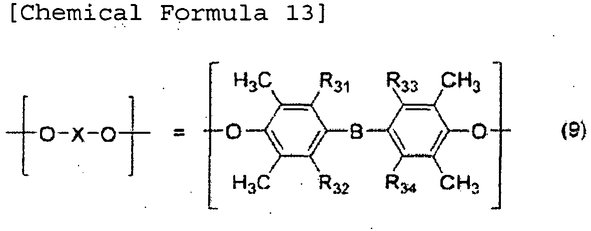 in which R₃₁, R₃₂, R₃₃, R₃₄ may be the same or different and are hydrogen atoms or methyl groups, and -B- is a linear, branched, or cyclic divalent hydrocarbon group having 20 or fewer carbon atoms. 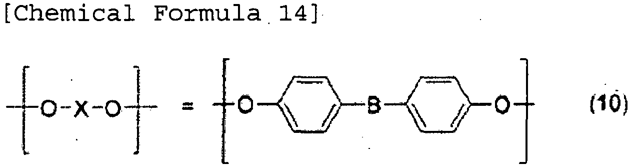 in which -B- is a linear, branched, or cyclic divalent hydrocarbon group having 20 or fewer carbon atoms.

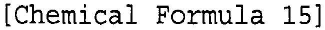

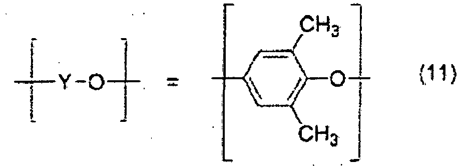

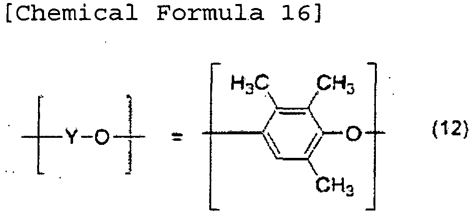

The method for producing modified polyphenylene ether having a structure represented by formula (4) is not particularly limited. For example, it can be produced by vinylbenzyl etherifying the terminal phenolic hydroxyl groups of a bifunctional phenylene ether oligomer obtained by oxidative coupling of a bifunctional phenol compound and a monofunctional phenol compound.

Such modified polyphenylene ether is also available, for example, from Mitsubishi Gas Chemical Co., Ltd. (OPE-2St 1200 and the like).

The polyphenylene ether has a number average molecular weight, by GPC in terms of polystyrene, ranging preferably 500-3000, more preferably 1000-2500. Stickiness is avoided when made into a coating film as long as the number average molecular weight is 500 or higher. Decreases in solubility in the solvent are avoided and dust falling, a phenomenon whereby resin dust falls from the prepreg, is suppressed during and after prepreg manufacture as long as the amount thereof is 3000 or lower.

The resin composition of the present invention has polyphenylene ether as the main component to lower the dielectric loss tangent, and the polyphenylene ether contents is 50 mass% or more versus the amount of resin composition.

Here, the amount of resin composition means the total mass of each component, excluding the inorganic filler and solvent, in the varnish.

The resin composition of the present invention may contain, in addition to polyphenylene ether, an epoxy resin, cyanate compound, polycarbonate, maleimide compound, oligomer of styrene and/or substituted styrene, phosphazene compound, phenol resin, silicone resin powder, or the like or a combination of two or more of them as a component of the resin composition.

The epoxy resin is not particularly limited as long as it has two or more epoxy groups per molecule. Specific examples include bisphenol A-type epoxy resin, bisphenol F-type epoxy resin, phenol novolak-type epoxy resin, bisphenol A novolak-type epoxy resin, biphenylaralkyl-type epoxy resin, cresol novolak-type epoxy resin, polyfunctional phenol-type epoxy resin, naphthalene-type epoxy resin, naphthalene-skeleton-modified novolak-type epoxy resin, phenolaralkyl-type epoxy resin, biphenyl-type epoxy resin, alicyclic epoxy resin, polyol-type epoxy resin, phosphorus-containing epoxy resin, glycidylamine, glycidyl ester, compounds obtained by epoxidation of double bonds such as butadiene and the like, compounds obtained by reacting hydroxyl group-containing silicone resins with epichlorohydrin, and the like. These may be halogenated.

Among them, bisphenol A-type epoxy resin, phenol novolak-type epoxy resin, cresol novolak-type epoxy resin, and naphthalene-skeleton-modified novolak-type epoxy resin are preferred.

The epoxy resin content of the resin composition relative to the amount of the resin composition is preferably in the range of 1-30 mass%, more preferably the range of 5-15 mass%, from the viewpoint of the electrical properties.

The cyanate is not particularly limited as long as the compound has two or more cyanate groups per molecule. Specific examples include bisphenol A-type cyanic acid ester resin and prepolymers thereof, naphthol aralkyl-type cyanic acid ester resin, 1,3- or 1,4-dicyanate benzene, 1,3,5-tricyanate benzene, 1,3-, 1,4-, 1,6-, 1,8-, 2,6-, or 2,7-dicyanate naphthalene, 1,3,6-tricyanate naphthalene, 4,4-dicyanate biphenyl, bis(4-dicyanatephenyl)methane, 2,2-bis(4-cyanatephenyl)propane, 2,2-bis(3,5-dibromo-4-cyanatephenyl)propane, bis(4-cyanatephenyl)ether, bis(4-cyanatephenyl)thioether, bis(4-cyanatephenyl)sulfone, tris(4-cyanatephenyl)phosphite, tris(4-cyanatephenyl)phosphate, and cyanates obtained by reacting novolak with cyanogen halide, and the like. Among them, bisphenol A-type cyanic acid ester resin and prepolymers thereof and naphthol aralkyl-type cyanic acid ester resin are especially preferred in terms of heat resistance. These cyanates can also be used individually or in suitable mixtures of two or more types.

The cyanate compound content relative to the amount of the resin composition is preferably in the range of 1-30 mass%, more preferably the range of 5-20 mass%, from the viewpoint of the electrical properties.

A brominated polycarbonate oligomer is preferred as polycarbonate from the viewpoint of imparting flame retardancy. The molecular weight of the brominated polycarbonate oligomer is not particularly limited, but those having a weight average molecular weight of 500-3500 are suitable.

The brominated polycarbonate oligomer content relative to the amount of the resin composition is preferably in the range of 1-10 mass%, more preferably the range of 2-8.5 mass%, and even more preferably the range of 2-5 mass%. When the brominated polycarbonate content is within the above range, not only can flame retardancy be imparted, but dust falling can also be suppressed.

The resin composition of the present invention may contain polystyrene having a crosslinked structure or an oligomer of styrene and/or substituted styrene which is a copolymer of styrene and another aromatic vinyl compound. Examples of aromatic vinyl compounds include, but are not limited to, α-methylstyrene, vinyl toluene, divinyl benzene, chlorostyrene, bromostyrene, and the like.

Examples of the method of producing the styrene oligomer include, but are not limited to, copolymerization with a divinyl compound, joint use of a peroxide, radiation treatment, and the like. Examples of the method of production include using a styrene monomer and divinyl benzene and conducting solution polymerization or suspension polymerization in the presence of a polymerization catalyst, and the like.

The shape of the styrene oligomer powder used in the present invention is not particularly limited. For example, any such as spherical, amorphous, or the like can be used.

The varnish of the present invention contains the above resin composition, inorganic filler, and polar solvent.

Any can be used as the inorganic filler contained in the varnish of the present invention as long as it is one generally used for laminated boards. Specific examples include natural silica, fused silica, synthetic silica, amorphous silica, hollow silica, and other such silicas, molybdenum oxide, zinc molybdate, and other such molybdenum compounds, zinc borate, zinc stannate, alumina, clay, kaolin, talc, calcined clay, calcined kaolin, calcined talc, mica, short glass fibers (E glass, D glass, and other such fine glass powders), hollow glass, and the like. Among them, silicas, talc, and short glass fibers are preferred in the present invention, and silicas are especially preferred from the viewpoint of the electrical properties. These inorganic fillers can be used individually or in suitable combinations of two or more types.

When silicas are used as the inorganic filler in the present invention, their average particle size (D50) is not particularly restricted, but preferred examples in consideration of the dispersiveness include mesoporous silica, spherical fused silica, spherical synthetic silica, hollow spherical silica, and the like having an average particle size (D50) of 0.1-3 µm. The flow properties during molding, breakage during use of a small-diameter drill bit, and the like can be improved if the average particle size (D50) is within the range of 0.1-3 µm. Here, D50 is the median diameter (median diameter) and is the diameter at which the masses are equal on the large side and the small side when the measured particle size distribution of the powder is divided in two. It is generally measured by wet laser diffraction-scattering.

The inorganic filler content of the varnish is preferably in the range of 10-200 parts by mass, ideally 40-100 parts by mass, per 100 parts by mass of resin composition from the viewpoint of the electrical properties.

The polar solvent contained in the varnish of the present invention contains at least propylene glycol monomethyl ether acetate and may further and may further include at least one selected from the group consisting of acetone, methyl ethyl ketone, N,N-dimethylformamide, and dimethylacetamide. Among them, methyl ethyl ketone and propylene glycol monomethyl ether acetate are preferred from the viewpoint of the solubility of the resin composition.

The polar solvent content of the varnish is not particularly limited, but 10-180 parts by mass per 100 total parts by mass of resin composition and inorganic filler is preferred from the viewpoint of the amount of residual solvent, uniform dispersion of the resin components, and ability to impregnate glass cloth.

The varnish of the present invention can contain other optional components, for example, silane coupling agents, wetting and dispersing agents, curing accelerators, crosslinking curing agents, polymerization inhibitors, and additives. As additives, ultraviolet absorbers, antioxidants, photopolymerization initiators, fluorescent whiteners, photosensitizers, dyes, pigments, tackifying agents, lubricants, defoaming agents, dispersants, levelling agents, brightening agents, and the like can be used in suitable combinations as desired.

The varnish of this embodiment can be prepared by an ordinary method. The preparation method is not particularly limited as long as it is a method that obtains a varnish uniformly containing the above-described resin composition, inorganic filler, polar solvent, and above-described other optional components. For example, a varnish of this embodiment can be prepared easily by combining the various components sequentially in a polar solvent and stirring thoroughly.

The prepreg of the present invention is obtained by impregnating or coating a base material with the above varnish and then drying.

The drying conditions during manufacture of the prepreg are not particularly limited as long as the residual polar solvent in the prepreg is brought to 3 mass% or less after drying.

A base material-impregnated prepreg size of 100-600 mm wide and 200-1000 mm long is preferred from the viewpoint of efficiently reducing the amount of residual solvent, and 300-550 mm wide and 300-700 mm long is more preferred.

A drying method consisting of drying by a nitrogen stream and drying using steam or another such heat source after drying for from 5 seconds to 10 minutes at room temperature is preferred as the drying method.

The drying temperature is preferably in the range of 120-220°C, more preferably the range of 150-200°C, from the viewpoint of the amount of residual solvent in the prepreg and prevention of accelerating curing of the resin composition.

The drying time is preferably 2-15 minutes, more preferably 3-10 minutes, from the viewpoint of the solvent drying efficiency and prevention of accelerating curing of the resin composition.

The pressure during drying may be either reduced pressure or normal pressure, but normal pressure is preferred from the viewpoint of cost.

The total amount of resin composition and inorganic filler relative to the total amount of the prepreg, including the base material, after the drying step is preferably in the range of 30-90 mass%.

The base material used when producing the prepreg in the present invention can be a known one used in materials for various types of printed wiring boards. Examples include E glass, D glass, S glass, T glass, NE glass, quartz, liquid-crystal polyester, and other such woven fabrics. The thickness of the woven fabric is not particularly limited, but those used for laminated boards in the range of 0.01-0.2 mm, especially a woven fabric that has been subjected to extreme spreading and sealing treatment, is suitable in terms of dimensional stability. Glass woven fabric whose surface was treated by epoxy silane, aminosilane, or other such silane coupling agents is also preferred in terms of heat resistance after moisture absorption. Liquid-crystal polyester woven fabric is preferred in terms of the electrical properties.

The metal foil-clad laminated board of the present invention is prepared by laminate molding using the above-described prepreg. Specifically, one or multiple sheets of the above prepreg are stacked, metal foil is placed on one or both sides thereof, and laminate molding are performed, for example, at a temperature of 180-220°C, heating time of 100-300 minutes, and surface pressure of 20-40 kg/cm². The thickness of the metal foil used is not particularly limited as long as it is one used as a material of printed wiring boards, but 3-35 µm is suitable. Electrolytic copper foil having a low-roughness matte surface is suitable, considering conductor loss in the high frequency region. As the method for producing a multilayered board, for example, 35 µm copper foil is placed on both sides of a sheet of prepreg of the present invention. After laminating and molding under the above conditions, an inner layer circuit is formed. This circuit is subjected to blackening treatment to make an inner layer circuit board. A multilayered board can also be made by combining this inner layer circuit board with the prepreg of the present invention and subjecting to laminating and molding.

The metal foil-clad laminated board of this embodiment can be used suitably as a printed wiring board. A printed wiring board can be produced by an ordinary method, and the production process is not particularly limited. An example of a method for producing a printed wiring board is now described. First, a metal foil-clad laminated board, for example, the aforementioned copper-clad laminated board or the like is prepared. Next, the surface of the metal foil-clad laminated board is subjected to etching to form an inner layer circuit, thereby obtaining an inner layer substrate. The inner layer circuit surface of this inner layer substrate is subjected to surface treatment to raise the adhesive strength as needed. A predetermined number of sheets of the above-described prepreg are then stacked on this inner layer circuit surface, metal foil for an outer layer circuit is laminated to the outside, and integral molding is performed by heat and pressure. A multilayered laminated board is produced in this way, which has an insulating layer comprised of the base material and cured thermosetting resin composition which are formed between the metal foil of the outer layer circuit and inner layer circuit. Next, after drilling this multilayered laminated board to make through-holes and via-holes, a plated metal film is formed to conduct the metal foil for the outer layer circuit and the inner layer circuit on the wall surfaces of these holes. Further etching is performed on the metal foil for the outer layer circuit to form an outer layer circuit, and thus a printed wiring board is produced.

The printed wiring board obtained in the above production example has an insulating layer and a conductor layer formed on the surface of this insulating layer, and the insulating layer is configured to include the above-described prepreg of the embodiment of the present invention.

### EXAMPLES

The present invention is explained in detail below through working examples and comparative examples. The present invention, however, is in no way limited by these examples.

### (Synthesis Example 1) Synthesis of α-naphthol aralkyl-type cyanic acid ester

A reactor equipped with a thermometer, stirrer, dropping funnel, and reflux cooler was precooled to 0-5°C by brine, and 7.47 g (0.122 mol) of cyanogen chloride, 9.75 g (0.0935 mol) of 35% hydrochloric acid, 76 mL of water, and 44 mL of methylene chloride were introduced into the reactor.

While maintaining the temperature inside this reactor at from -5 to +5°C and the pH at 1 or lower, a solution, obtained by dissolving 20 g (0.0935 mol) of α-naphthol aralkyl resin in which R in formula (2) were all hydrogen atoms (SN485, OH equivalent weight: 214 g/Eq, softening point: 86°C, manufactured by Nippon Steel Chemical Co., Ltd.) and 14.16 g (0.14 mol) of triethylamine in 92 mL of methylene chloride, was added dropwise over one hour from the dropping funnel while stirring. After dropwise addition had been completed, 4.72 g (0.047 mol) of triethylamine was further added dropwise over 15 minutes.

After dropwise addition had been completed, followed by stirring for 15 minutes at the same temperature, the reaction solution was separated, and the organic layer was collected. After washing the organic layer obtained twice with 100 mL of water, the methylene chloride was removed under reduced pressure by an evaporator, and 23.5 g of a cyanic acid ester of α-naphthol aralkyl resin (α-naphthol aralkyl-type cyanic acid ester) was finally obtained by concentrating and drying for one hour at 80°C.

### (Working Example 1)

Sixty-nine parts by mass of polyphenylene ether in which -(O-X-O)- in general formula (4) is represented by formula (8), -(Y-O)- is represented by formula (11), and a and b are 0-100 (OPE-2St 1200, manufactured by Mitsubishi Gas Chemical Co., Ltd., number average molecular weight 1187, vinyl group equivalent weight: 590 g/Eq), 11.5 parts by mass of brominated bisphenol A-type epoxy resin 1 (E153, manufactured by DIC, epoxy equivalent weight: 400 g/Eq, weight average molecular weight 400-800), 1.0 part by mass of cresol novolak-type epoxy resin (N680, manufactured by DIC, epoxy equivalent weight: 215 g/Eq, weight average molecular weight 2400), 13.5 parts by mass of bisphenol A-type cyanic acid ester (CA210, manufactured by Mitsubishi Gas Chemical Co., Ltd., cyanate equivalent weight: 139 g/Eq), 5 parts by mass of brominated polycarbonate (FG8500, manufactured by Teijin Chemicals, Ltd.), 50 parts by mass of spherical silica (SC2050, manufactured by Admatechs Co., Ltd., average particle size 0.5 µm), and 35 parts by mass each of methyl ethyl ketone and propylene glycol monomethyl ether acetate were mixed, and a varnish diluted to a solids fraction of 65 mass% was obtained. E glass cloth 0.08 mm thick was impregnated and coated with the varnish obtained, heated and dried for five minutes at 170°C using a dryer (explosion-proof steam dryer, manufactured by Takasugi Seisakusho), and a prepreg of 55 mass% resin composition was obtained. Eight sheets of this 55 mass% prepreg were stacked, 18 µm copper foil (3EC-III, manufactured by Mitsui Mining & Smelting Co., Ltd.) was placed on both sides, vacuum pressing was performed for 150 minutes at a pressure of 30 kg/cm² and temperature of 210°C, and a 18 µm copper-clad laminated board with 0.8 mm thickness was obtained. The volatile fraction, flammability, dielectric loss tangent, and dust falling amount were evaluated using the prepreg and copper-clad laminated board obtained. The results are shown in Table 1.

### (Measurement methods)

1) Volatile fraction: The prepreg (size: 520 mm × 345 mm) was dried (160°C, 15 minutes) immediately after manufacture, and the prepreg weight loss before and after was calculated. Loss of 3 mass% or less and loss of more than 3 mass% were indicated by (○) and (×), respectively.
2) Flammability: After removing the copper foil from the copper-clad laminated board by etching, the flammability was evaluated by a UL 94 vertical flame test. Results of V-0 and V-1 were indicated by (⊙) and (○), respectively.
3) Dielectric loss tangent: Using a test piece obtained by removing the copper foil from a 0.8 mm thick copper-clad laminated board, the dielectric loss tangent at 10 GHz was measured twice by the cavity perturbation method (Agilent 8722ES, manufactured by Agilent Technology). An average value lower than 0.0065, 0.0065-0.007, and higher than 0.007 were indicated by (⊙), (○), and (×), respectively.
4) Dust falling amount: The prepreg (size: 40 mm × 345 mm) was placed on an aluminum sheet, and a cylindrical SUS roll (weight: 1 kg, diameter: 25 mm) was passed over the prepreg. The prepreg weight loss before and after was calculated. Average value of three measurements of less than 5 wt% and from 5 wt% to less than 10 wt% were indicated by (⊙) and (○), respectively.

### (Working Example 2)

This example was the same as Working Example 1 except that 13.5 parts by mass of the α-naphthol aralkyl-type cyanic acid ester obtained in Synthesis Example 1 was used instead of the bisphenol A-type cyanic acid ester used in Working Example 1.

### (Working Example 3)

This example was the same as Working Example 1 except that the bisphenol A-type cyanic acid ester used in Working Example 1 and the α-naphthol aralkyl-type cyanic acid ester used in Working Example 2 were used at amounts of 7.5 parts by mass and 6 parts by mass, respectively.

### (Working Example 4)

This example was the same as Working Example 3 except that the polyphenylene ether, cresol novolak-type epoxy resin, brominated bisphenol A-type epoxy resin 1, and brominated polycarbonate used in Working Example 1 were used at amounts of 67.5 parts by mass, 3.0 parts by mass, 7.5 parts by mass, and 8.5 parts by mass, respectively.

### (Working Example 5)

This example was the same as Working Example 3 except that the polyphenylene ether, brominated bisphenol A-type epoxy resin 1, and brominated polycarbonate used in Working Example 1 were used at amounts of 71.5 parts by mass, 13.0 parts by mass, and 2.0 parts by mass, respectively; and cresol novolak-type epoxy resin was not used.

### (Working Example 6)

This example was the same as Working Example 3 except that: the polyphenylene ether and bisphenol A-type cyanic acid ester used in Working Example 1 were used at amounts of 81.8 parts by mass and 5.7 parts by mass, respectively; the α-naphthol aralkyl-type cyanic acid ester used in Working Example 2 was used at an amount of 4.5 parts by mass; brominated bisphenol A-type epoxy resin 1, cresol novolak-type epoxy resin, and brominated polycarbonate were not used; and 3.4 parts by mass of brominated bisphenol A-type epoxy resin 2 (DER515, manufactured by Dow Chemical Co., epoxy equivalent weight: 550 g/Eq, weight average molecular weight 1060-1120), 3.4 parts by mass of brominated novolak-type epoxy resin (BREN, manufactured by Nippon Kayaku Co., Ltd., epoxy equivalent weight: 285 g/Eq, weight average molecular weight 1940), and 1.1 parts by mass of bisphenol A-type epoxy resin 1 (828EL, manufactured by Mitsubishi Chemical Co., Ltd., epoxy equivalent weight: 190 g/Eq, weight average molecular weight 368-388) were used.

### (Working Example 7)

This example was the same as Working Example 6 except that the brominated novolak-type epoxy resin used in Working Example 6 was not used; and the cresol novolak-type epoxy resin used in Working Example 1 was used at an amount of 3.4 parts by mass.

### (Working Example 8)

This example was the same as Working Example 3 except that: the polyphenylene ether, cresol novolak-type epoxy resin, and bisphenol A-type cyanic acid ester used in Working Example 1 were used at amounts of 52.0 parts by mass, 9.0 parts by mass, and 15.0 parts by mass, respectively; and the α-naphthol aralkyl-type cyanic acid ester used in Working Example 2 was used at an amount of 12.0 parts by mass; brominated bisphenol A-type epoxy resin 1 and brominated polycarbonate were not used; the bisphenol A-type epoxy resin 1 used in Working Example 6 was used at an amount of 3.0 parts by mass; and 9.0 parts by mass of bisphenol A-type epoxy resin 2 (E-1051, manufactured by DIC, epoxy equivalent weight: 475 g/Eq, weight average molecular weight 900) was used.

### (Working Example 9)

This example was the same as Working Example 8 except that: the polyphenylene ether and cresol novolak-type epoxy resin used in Working Example 1, the bisphenol A-type epoxy resin 1 used in Working Example 6, the bisphenol A-type epoxy resin 2 and bisphenol A-type cyanic acid ester used in Working Example 8, and the α-naphthol aralkyl-type cyanic acid ester used in Working Example 2 were used at amounts of 68.0 parts by mass, 6.0 parts by mass, 2.0 parts by mass, 6.0 parts by mass, 10.0 parts by mass, and 8.0 parts by mass, respectively.

### (Working Example 10)

This example was the same as Working Example 8 except that: the polyphenylene ether and cresol novolak-type epoxy resin used in Working Example 1, the bisphenol A-type epoxy resin 1 used in Working Example 6, the bisphenol A-type epoxy resin 2 and bisphenol A-type cyanic acid ester used in Working Example 8, and the α-naphthol aralkyl-type cyanic acid used in Working Example 2 were used at amounts of 76.0 parts by mass, 4.5 parts by mass, 1.5 parts by mass, 4.5 parts by mass, 7.5 parts by mass, and 6.0 parts by mass, respectively.

### (Working Example 11)

This example was the same as Working Example 1 except that: the polyphenylene ether and cresol novolak-type epoxy resin used in Working Example 1, the bisphenol A-type epoxy resin 2 and bisphenol A-type cyanic acid ester used in Working Example 8, and the α-naphthol aralkyl-type cyanic acid ester and brominated polycarbonate used in Working Example 2 were used at amounts of 69.0 parts by mass, 5.0 parts by mass, 2.0 parts by mass, 5.0 parts by mass, 4.0 parts by mass, and 15.0 parts by mass, respectively; and brominated bisphenol A-type epoxy resin 1 was not used.

### (Comparative Example 1)

A prepreg and copper-clad laminated board were obtained in the same way as in Working Example 1 except that the dryer temperature and drying time were 100°C and 5 minutes, respectively, and the volatile fraction was 3 wt% or higher. The results are shown in Table 1.

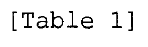

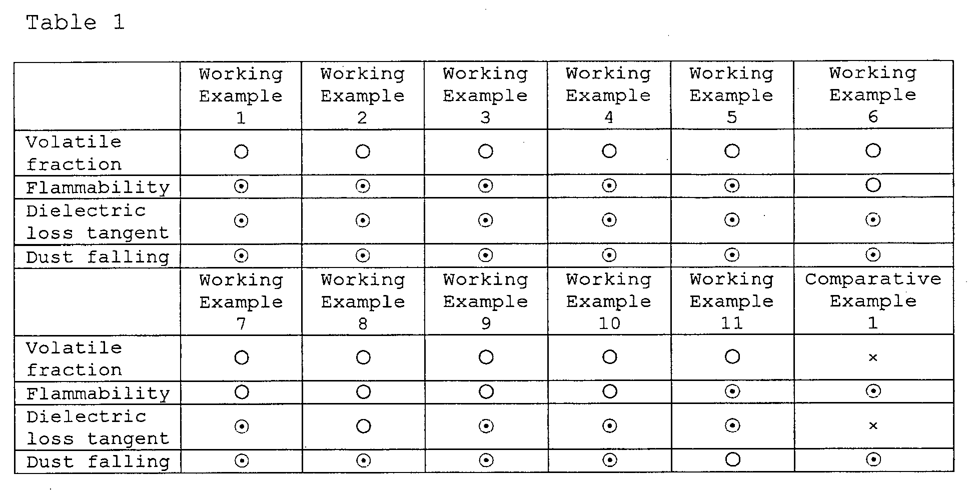

## Claims

1. A prepreg produced by impregnating or coating a base material with a varnish comprising an inorganic filler, a polar solvent containing at least propylene glycol monomethyl ether acetate, and a resin composition comprising 50 mass% or more of polyphenylene ether, and subjecting the base material treated to a drying step, wherein
the polar solvent content of the prepreg is 3 mass% or less.

2. The prepreg according to Claim 1, wherein the polar solvent further contains at least one selected from the group consisting of acetone, methyl ethyl ketone, N,N-dimethylformamide, and dimethylacetamide.

3. The prepreg according to Claim 1 or 2, wherein the polar solvent content of the varnish is 10-180 parts by mass per 100 total parts by mass of the resin composition and the inorganic filler.

4. The prepreg according to any of Claims 1-3, wherein a treatment is conducted for 2-30 minutes at 120-200°C in the drying step.

5. The prepreg according to any of Claims 1-4, wherein the resin composition further comprises at least one selected from the group consisting of an epoxy resin, phenol resin, cyanate compound, and polycarbonate.

6. The prepreg according to any of Claims 1-5, wherein the polyphenylene ether has a number average molecular weight ranging 500-3000.

7. The prepreg according to any of Claims 1-6, wherein the polyphenylene ether is represented by general formula (4): 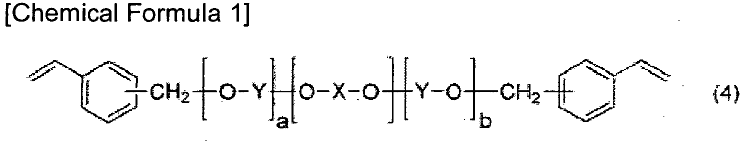 in which
-(O-X-O)- constitutes a structure represented by general formula (5): 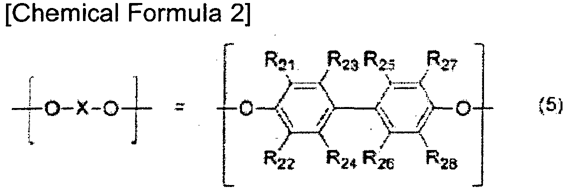 in which R₂₁, R₂₂, R₂₃, R₂₇, R₂₈ may be the same or different and are phenyl groups or alkyl groups having six or fewer carbon atoms; R₂₄, R₂₅, R₂₆ may be the same or different and are hydrogen atoms, phenyl groups or alkyl groups having six or fewer carbon atoms) or general formula (6): 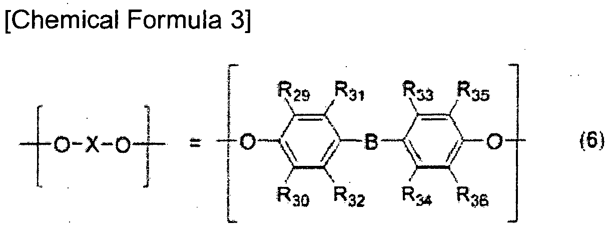 in which R₂₉, R₃₀, R₃₁ R₃₂, R₃₃, R₃₄, R₃₅, R₃₆ may be the same or different and are hydrogen atoms, phenyl groups or alkyl groups having six or fewer carbon atoms; -B- is a linear, branched, or cyclic divalent hydrocarbon group having 20 or fewer carbon atoms; and
-(Y-O)- is represented by general formula (7): 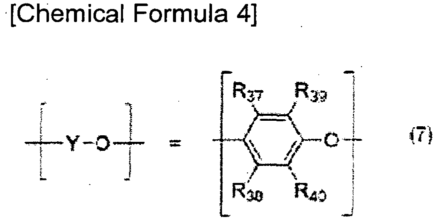 in which R₃₉, R₄₀ may be the same or different and are phenyl groups or alkyl groups having six or fewer carbon atoms; R₃₇, R₃₈ may be the same or different and are hydrogen atoms, phenyl groups or alkyl groups having six or fewer carbon atoms); where one or more types of structures are arranged randomly and a and b represent integers of 0-100, at least one of which is not zero.

8. The prepreg according to any of Claims 1-7, wherein the resin composition comprises an epoxy resin and the epoxy resin content of the resin composition is 1-30 mass%.

9. The prepreg according to any of Claims 1-8, wherein the resin composition comprises a cyanate compound and the cyanate compound content of the resin composition is 1-30 mass%.

10. The prepreg according to any of Claims 1-9, wherein the resin composition comprises a brominated polycarbonate oligomer and the polycarbonate oligomer content of the resin composition is 2-10 mass%.

11. The prepreg according to any of Claims 1-10, wherein the inorganic filler is at least one selected from the group consisting of natural silica, fused silica, synthetic silica, amorphous silica, hollow silica, short glass fibers, and talc.

12. The prepreg according to any of Claims 1-11, wherein an amount of dust falling as measured as follows is 5 mass% or less: placing the prepreg having the size of 40 mm × 345 mm on an aluminum sheet, passing a cylindrical SUS roll having weight of 1 kg and diameter of 25 mm over the prepreg, calculating the prepreg weight loss before and after, and calculating an average value of three measurements of the prepreg weight loss.

13. A laminated board produced using the prepreg according to any of Claims 1-12, wherein the laminated board has a dielectric loss tangent at 10 GHz of 0.001-0.007, and wherein the dielectric loss tangent at 10 GHz is measured by a cavity perturbation method.

14. A metal foil-clad laminated board produced using the prepreg according to any of Claims 1-12 and metal foil.

15. A printed wiring board comprising an insulating layer and a conductor layer formed on the surface of the insulating layer, wherein the insulating layer comprises the prepreg according to any of Claims 1-12, and has a dielectric loss tangent at 10 GHz of 0.001-0.007, and wherein the dielectric loss tangent at 10 GHz is measured by a cavity perturbation method.

## Patentansprüche

1. Prepreg, hergestellt durch Imprägnieren oder Beschichten eines Grundmaterials mit einem Lack, umfassend einen anorganischen Füllstoff, ein polares Lösungsmittel, enthaltend mindestens Propylenglycolmonomethyletheracetat, und eine Harzzusammensetzung, umfassend 50 Massen-% oder mehr eines Polyphenylenethers, und Unterziehen des behandelten Grundmaterials einem Trocknungsschritt, wobei
der polare Lösungsmittelgehalt des Prepregs 3 Massen-% oder weniger beträgt.

2. Prepreg nach Anspruch 1, wobei das polare Lösungsmittel weiter mindestens eines, ausgewählt aus der Gruppe, bestehend aus Aceton, Methylethylketon, N,N-Dimethylformamid und Dimethylacetamid, enthält.

3. Prepreg nach Anspruch 1 oder 2, wobei der polare Lösungsmittelgehalt des Lacks 10-180 Massenteile pro 100 Gesamtmassenteile der Harzzusammensetzung und des anorganischen Füllstoffes beträgt.

4. Prepreg nach einem der Ansprüche 1-3, wobei eine Behandlung für 2-30 Minuten bei 120-200°C in dem Trocknungsschritt durchgeführt wird.

5. Prepreg nach einem der Ansprüche 1-4, wobei die Harzzusammensetzung weiter mindestens eines, ausgewählt aus der Gruppe, bestehend aus einem Epoxidharz, einem Phenolharz, einer Cyanatverbindung und einem Polycarbonat, umfasst.

6. Prepreg nach einem der Ansprüche 1-5, wobei der Polyphenylenether ein zahlengemitteltes Molekulargewicht im Bereich von 500-3000 aufweist.

7. Prepreg nach einem der Ansprüche 1-6, wobei der Polyphenylenether durch die allgemeine Formel (4) dargestellt ist: 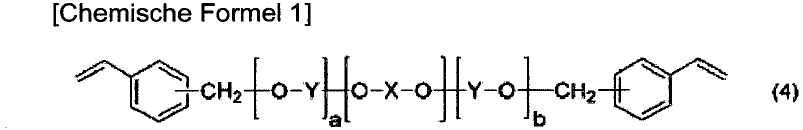 in welcher
-(O-X-O)- eine Struktur, dargestellt durch die allgemeine Formel (5), konstituiert: 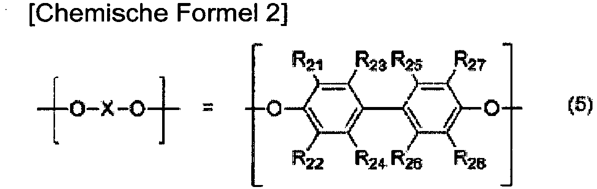 in welcher R₂₁, R₂₂, R₂₃, R₂₇, R₂₈ gleich oder verschieden sein können und Phenylgruppen oder Alkylgruppen mit sechs oder weniger Kohlenstoffatomen sind; R₂₄, R₂₅, R₂₆ gleich oder verschieden sein können und Wasserstoffatome, Phenylgruppen oder Alkylgruppen mit sechs oder weniger Kohlenstoffatomen sind)
oder allgemeine Formel (6): 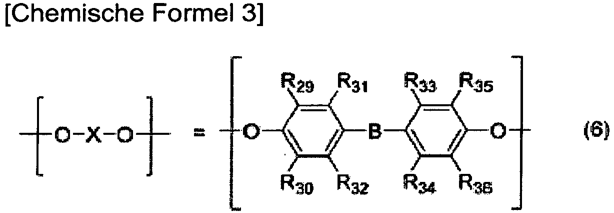 in welcher R₂₉, R₃₀, R₃₁ R₃₂, R₃₃, R₃₄, R₃₅, R₃₆ gleich oder verschieden sein können und Wasserstoffatome, Phenylgruppen oder Alkylgruppen mit sechs oder weniger Kohlenstoffatomen sind; -B- eine lineare, verzweigte oder zyklische zweiwertige Kohlenwasserstoffgruppe mit 20 oder weniger Kohlenstoffatomen ist; und
-(Y-O)- durch die allgemeine Formel (7) dargestellt ist: 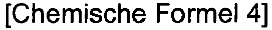 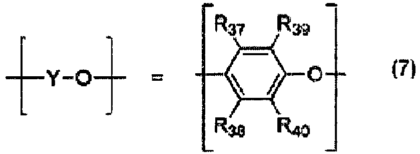 in welcher R₃₉, R₄₀ gleich oder verschieden sein können und Phenylgruppen oder Alkylgruppen mit sechs oder weniger Kohlenstoffatomen sind; R₃₇, R₃₈ gleich oder verschieden sein können und Wasserstoffatome, Phenylgruppen oder Alkylgruppen mit sechs oder weniger Kohlenstoffatomen sind); wobei eine oder mehrere Arten von Strukturen zufällig angeordnet sind und a und b ganze Zahlen von 0-100 darstellen, von denen mindestens eine nicht null ist.

8. Prepreg nach einem der Ansprüche 1-7, wobei die Harzzusammensetzung ein Epoxidharz umfasst und der Epoxidharzgehalt der Harzzusammensetzung 1-30 Massen-% beträgt.

9. Prepreg nach einem der Ansprüche 1-8, wobei die Harzzusammensetzung eine Cyanatverbindung umfasst und der Cyanatverbindungsgehalt der Harzzusammensetzung 1-30 Massen-% beträgt.

10. Prepreg nach einem der Ansprüche 1-9, wobei die Harzzusammensetzung ein bromiertes Polycarbonatoligomer umfasst und der Polycarbonatoligomergehalt der Harzzusammensetzung 2-10 Massen-% beträgt.

11. Prepreg nach einem der Ansprüche 1-10, wobei der anorganische Füllstoff mindestens eines, ausgewählt aus der Gruppe, bestehend aus natürlichem Siliziumdioxid, zusammengeschmolzenem Siliziumdioxid, synthetischem Siliziumdioxid, amorphem Siliziumdioxid, hohlem Siliziumdioxid, Kurzglasfasern und Talk, ist.

12. Prepreg nach einem der Ansprüche 1-11, wobei eine Menge von herabfallendem Abrieb, wie nachstehend gemessen, 5 Massen-% oder weniger beträgt: Platzieren des Prepregs mit der Größe von 40 mm × 345 mm auf ein Aluminiumblech, Führen einer zylindrischen SUS-Rolle mit einem Gewicht von 1 kg und einem Durchmesser von 25 mm über das Prepreg, Berechnen des Prepreggewichtsverlusts vorher und nachher, und Berechnen eines gemittelten Werts von drei Messungen des Prepreggewichtsverlusts.

13. Laminierte Platte, hergestellt unter Verwendung des Prepregs nach einem der Ansprüche 1-12, wobei die laminierte Platte einen dielektrischen Verlusttangens bei 10 GHz von 0,001-0,007 aufweist, und wobei der dielektrische Verlusttangens bei 10 GHz durch ein Hohlraumstörungsverfahren gemessen wird.

14. Metallfolienkaschierte laminierte Platte, hergestellt unter Verwendung des Prepregs nach einem der Ansprüche 1-12 und einer Metallfolie.

15. Leiterplatte, umfassend eine Isolierschicht und eine Leiterschicht, gebildet auf der Oberfläche der Isolierschicht, wobei die Isolierschicht das Prepreg nach einem der Ansprüche 1-12 umfasst und einen dielektrischen Verlusttangens bei 10 GHz von 0,001-0,007 aufweist, und wobei der dielektrische Verlusttangens bei 10 GHz durch ein Hohlraumstörungsverfahren gemessen wird.

## Revendications

1. Pré-imprégné préparé par imprégnation ou revêtement d'un matériau de base à l'aide d'un vernis comprenant une charge inorganique, un solvant polaire contenant au moins l'acétate du monométhyléther de propylèneglycol, et une composition de résine comprenant 50% en masse ou plus de poly(éther de phénylène), et par une étape de séchage du matériau de base traité, où la teneur en solvant polaire du pré-imprégné se situe à 3% en masse ou moins.

2. Pré-imprégné selon la revendication 1, où le solvant polaire contient en outre, au moins un composant choisi parmi le groupe consistant en l'acétone, la méthyléthylcétone, le N,N-diméthylformamide et le diméthylacétamide.

3. Pré-imprégné selon la revendication 1 ou 2, où la teneur en solvant polaire du vernis se situe dans l'intervalle allant de 10 à 180 parties en masse par 100 parties en masse de la totalité de la composition de résine et de la charge inorganique.

4. Pré-imprégné selon l'une quelconque des revendications 1 à 3, où un traitement est réalisé pendant 2 à 30 minutes à 120-200°C pendant l'étape de séchage.

5. Pré-imprégné selon l'une quelconque des revendications 1 à 4, où la composition de résine comprend en outre, au moins un composant choisi parmi le groupe consistant en une résine époxy, une résine phénolique, un composé cyanate, et un polycarbonate.

6. Pré-imprégné selon l'une quelconque des revendications 1 à 5, où le poly(éther de phénylène) présente un poids moléculaire moyen en nombre situé dans l'intervalle allant de 500 à 3000.

7. Pré-imprégné selon l'une quelconque des revendications 1 à 6, où le poly(éther de phénylène) est représenté par la formule générale (4) : 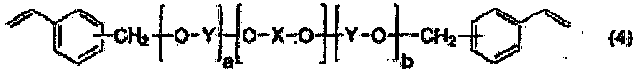 dans laquelle -(O-X-O)- représente une structure de formule générale (5) : 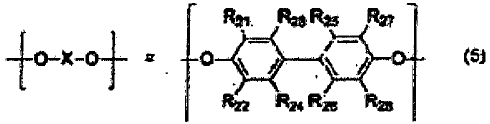 dans laquelle R₂₁, R₂₂, R₂₃, R₂₇, R₂₈ peuvent être identiques ou différents et sont des groupes phényle ou des groupes alkyle ayant six atomes de carbone ou moins ; R₂₄, R₂₅, R₂₆ peuvent être identiques ou différents et sont l'atome d'hydrogène, des groupes phényle ou des groupes alkyle ayant six atomes de carbone ou moins, ou de formule générale (6) : 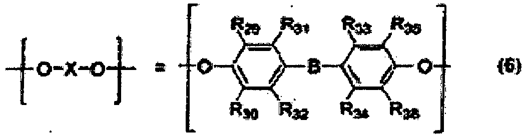 dans laquelle R₂₉, R₃₀, R₃₁, R₃₂, R₃₃, R₃₄, R₃₅, R₃₆ peuvent être identiques ou différents et sont l'atome d'hydrogène, des groupes phényle ou des groupes alkyle ayant six atomes de carbone ou moins ; -B- est un groupe hydrocarboné bivalent linéaire, ramifié ou cyclique ayant 20 atomes de carbone ou moins, et
-(Y-O)- est représenté par la formule générale (7) : 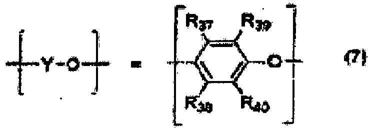 dans laquelle R₃₉, R₄₀ peuvent être identiques ou différents et sont des groupes phényle ou des groupes alkyle ayant six atomes de carbone ou moins ; R₃₇, R₃₈ peuvent être identiques ou différents et sont l'atome d'hydrogène, des groupes phényle ou des groupes alkyle ayant six atomes de carbone ou moins ; où un ou plusieurs types de structure sont agencés de manière statistique et a et b représentent des entiers allant de 0 à 100, au moins l'un d'eux étant différent de zéro.

8. Pré-imprégné selon l'une quelconque des revendications 1 à 7, où la composition de résine comprend une résine époxy et où la teneur en résine époxy de la composition de résine se situe dans l'intervalle allant de 1 à 30% en masse.

9. Pré-imprégné selon l'une quelconque des revendications 1 à 8, où la composition de résine comprend un composé cyanate et où la teneur en composé cyanate de la composition de résine se situe dans l'intervalle allant de 1 à 30% en masse.

10. Pré-imprégné selon l'une quelconque des revendications 1 à 9, où la composition de résine comprend un oligomère de polycarbonate bromé et où la teneur en oligomère de polycarbonate de la composition de résine se situe dans l'intervalle allant de 2 à 10% en masse.

11. Pré-imprégné selon l'une quelconque des revendications 1 à 10, où la charge inorganique est au moins l'une choisie parmi le groupe consistant en la silice naturelle, la silice fondue, la silice synthétique, la silice amorphe, la silice creuse, de courtes fibres de verre, et le talc.

12. Pré-imprégné selon l'une quelconque des revendications 1 à 11, où la quantité de poussière perdue mesurée de la manière décrite ci-après, se situe à 5% en masse ou moins : disposer un pré-imprégné ayant les dimensions 40 mm x 345 mm sur une feuille en aluminium, passer sur le pré-imprégné un rouleau cylindrique SUS de 1 kg et de 25 mm de diamètre, calculer la perte pondérale du pré-imprégné entre avant et après, et calculer une valeur moyenne de trois mesures de perte de poids de pré-imprégné.

13. Plaque stratifiée produite à l'aide du pré-imprégné selon l'une quelconque des revendications 1 à 12, où la plaque stratifiée présente une tangente de perte diélectrique à 10 GHz située dans l'intervalle allant de 0,001 à 0,007, et où la tangente de perte diélectrique à 10 GHz est mesurée par un procédé de perturbation de cavité.

14. Plaque stratifiée revêtue d'une feuille métallique produite en utilisant le pré-imprégné selon l'une quelconque des revendications 1 à 12 et une feuille métallique.

15. Circuit imprimé comprenant une couche isolante et une couche conductrice formée sur la surface de la couche isolante, la couche isolante comprenant le pré-imprégné selon l'une quelconque des revendications 1 à 12 et ayant une tangente de perte diélectrique à 10 GHz située dans l'intervalle allant de 0,001 à 0,007, la tangente de perte diélectrique à 10 GHz étant mesurée par un procédé de perturbation de cavité.
